(19) **Europäisches Patentamt / European Patent Office / Office européen des brevets**

(11) **EP 3 082 165 B1**

(12) **EUROPEAN PATENT SPECIFICATION**

(45) Date of publication and mention of the grant of the patent:
**28.07.2021  Bulletin 2021/30**

(21) Application number: **15202569.8**

(22) Date of filing: **23.12.2015**

(51) Int Cl.:
*H01L 27/146* (2006.01)

(54) **A PIXEL HAVING A PLURALITY OF PINNED PHOTODIODES**

PIXEL MIT MEHREREN VERSTIFTETEN PHOTODIODEN

PIXEL AYANT UNE PLURALITÉ DE PHOTODIODES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **17.04.2015  GB 201506569**
**17.12.2015  US 201514972253**

(43) Date of publication of application:
**19.10.2016  Bulletin 2016/42**

(73) Proprietor: **STMicroelectronics (Research & Development)**
**Limited**
**Buckinghamshire SL7 1EY (GB)**

(72) Inventor: **STARK, Laurence**
**Edinburgh, EH10 5PE (GB)**

(74) Representative: **Style, Kelda Camilla Karen**
**Page White & Farrer**
**Bedford House**
**John Street**
**London, WC1N  2BF (GB)**

(56) References cited:
WO-A1-2015/006008      US-A1- 2006 043 440
US-A1- 2013 248 938      US-A1- 2014 284 665

• MA JIAJU ET AL: "A Pump-Gate Jot Device With High Conversion Gain for a Quanta Image Sensor", IEEE JOURNAL OF THE ELECTRON DEVICES SOCIETY, IEEE, USA, vol. 3, no. 2, 1 March 2015 (2015-03-01), pages 73-77, XP011573690, DOI: 10.1109/JEDS.2015.2390491 [retrieved on 2015-02-20]
• J. Michelot: "Back Illuminated Vertically Pinned Photodiode with in Depth Charge Storage", , 1 January 2011 (2011-01-01), XP055288887, Retrieved from the Internet: URL:http://www.imagesensors.org/Past%20Workshops/2011%20Workshop/2011%20Papers/R09_M ichelot_VerticalPPD.pdf [retrieved on 2016-07-15]
• None

EP 3 082 165 B1

# Description

The disclosure relates to a pixel having a plurality of pinned photodiodes.

Image sensors using pinned photodiode pixels, typically implemented in CMOS architecture, are known. Such image sensors have many applications. In some applications, an array of pixels may be provided.

WO2015/006008A1 discloses image sensor pixels having low full-well capacity and high sensitivity for applications such as DIS, qDIS, single/multi bit QIS. Some embodiments disclose an image sensor pixel architecture which comprises a transfer gate, a floating diffusion region both formed on a first surface of a semiconductor substrate and a buried-well vertically pinned photodiode having a charge accumulation/storage region disposed substantially or entirely beneath the transfer gate.

According to an embodiment of the present invention there is provided a pixel according to claim 1.

The pixel may comprise a source follower transistor and wherein the or each floating diffusion implant may be provided with a contact, a gate of said source follower transistor being provided with a contact, said contacts each being in contact with a common metal part. Deep trench isolation may be provided around the pixel.

According to another embodiment of the present invention there is provided an array of pixels according to claim 5.

According to a further embodiment of the present invention there is provided an electronic device according to claim 6.

A pixel may comprise a source follower transistor and wherein each floating diffusion implant is provided with a contact, a gate of said source follower transistor being provided with a contact, said contacts each being in contact with a common metal part.

Deep trench isolation may be provided around the pixel.

At least one transfer gate may be created using a capacitive deep trench isolation process.

The invention relates to a pixel, an array of pixels and an electronics device as set forth in the claims.

Reference is now made by way of example only to the accompanying drawings in which:

Figure 1 shows a cross-section of a pixel of a first aspect;
Figure 2 shows a cross-section of the aspect of Figure 1 with a colour filter;
Figure 3 shows a plan view of the pixel of Figure 1;
Figure 4 shows a circuit showing a pixel of an aspect;
Figure 5 shows a cross-section of a pixel of a further aspect with a shared floating diffusion implant;
Figure 6 shows a cross-section of a pixel of a further aspect with a shared transfer gate;
Figure 7 shows a cross-section of a pixel of a further aspect with three pinned photodiodes and a shared transfer gate;
Figure 8 shows a cross-section of a pixel of a further aspect with three pinned photodiodes having a two-stage charge transfer according to an embodiment of the invention;
Figure 9a shows a method for forming a diode structure of some aspects using shallow trench isolation according to an embodiment of the invention;
Figure 9b shows a method for forming a diode structure of some aspects using deep trench isolation according to an embodiment of the invention;
Figure 10 shows another aspect of a pixel with horizontally oriented fins and a vertical transfer gate;
Figure 11 shows another aspect of a pixel with two lateral pinned photodiodes and two floating diffusion implants;
Figure 12 shows another aspect of a pixel with two lateral pinned photodiodes and a single floating diffusion implant;
Figure 13 shows another aspect of a pixel with three lateral pinned photodiodes and three floating diffusion implants;
Figure 14 shows another aspect of a pixel with four lateral pinned photodiodes and two floating diffusion implants; and
Figure 15 shows a device having an array of pixels.

Global shutter pixels may have more transistors than rolling blade pixels and so may be larger. As far as rolling blade pixels are concerned, there may be a benefit of larger pixels for rolling blade pixels as they can collect more light.

If a rolling blade shutter arrangement is used, pixels are processed line by line, one being integrated and another being read out for each movement of the shutter. The shutter moves over the array so that all the pixels are exposed for the same amount of time, but not all at the same time.

If a global shutter arrangement is used, all pixels are simultaneously released from reset and start to integrate simultaneously. After a specific period, all the pixels are then read out simultaneously into a temporary storage, which may be located inside the pixel. This temporary storage is then scanned out row by row where the signal is amplified or converted into a digital value.

The amount of charge that a pinned photodiode can collect before saturating is known as the full-well. It is desirable to have a large full-well so that many photons can be collected from the incoming illumination and the imaging range extended. Using a vertical pinned photodiode configuration provides "in-depth" charge storage which can be used to maximise the full-well capacity for a given pixel area by increasing the extent of the well into the silicon substrate. This is particularly advantageous for example, for small pixels. A vertical pinned photodiode configuration allows an increase in the full-well capacity without the associated increase the pixel's 2D footprint. The vertical pinned photodiode structure may provide an improved quantum efficiency QE for the pixel, since the pinned photodiode may cover most of the depth of the silicon from the front side to back side. Quantum efficiency is the ratio between the number of photons incident on the pixel and the number of electrons collected. QE=Number of electrons/Number of photons.

The depletion potential of a vertical pinned photodiode structure is influenced by the smallest dimension of the diode, which may prevent that structure from being used in larger pixels. For some pixels, such as the 4T pixel, planar pinned photodiodes are used to address this problem. However these pixels may have a shallow junction depth which may lead to a reduced QE. Typically a planar photodiode has a reduced storage capacity per unit area compared to the vertical pinned photodiode.

The inventors have recognised that to improve image quality, it may be desirable that the depletion potential of a pinned photodiode be kept as low as possible and the full-well capacity should be as high as possible. This may be achieved in a larger pixel by stacking several planar pinned photodiodes. This may also maximise the dynamic range of the pixel.

The photon shot noise (PSN) in electrons, is equal to the square-root of the number of electrons collected. Hence the maximum signal-noise ratio (SNR) = SQRT(full-well electrons). Consequently, reducing the maximum full-well electrons reduces the maximum SNR resulting in an image with greater noise.

It may in some aspects be advantageous to increase the size of the pinned photodiode without an increase in the depletion potential in order to keep the full-well capacity of the pinned photodiode large and the maximum SNR large.

Some aspects will now be described. In some aspects, vertical pinned photodiodes may be used. In some aspects, lateral pinned photodiodes may be used.

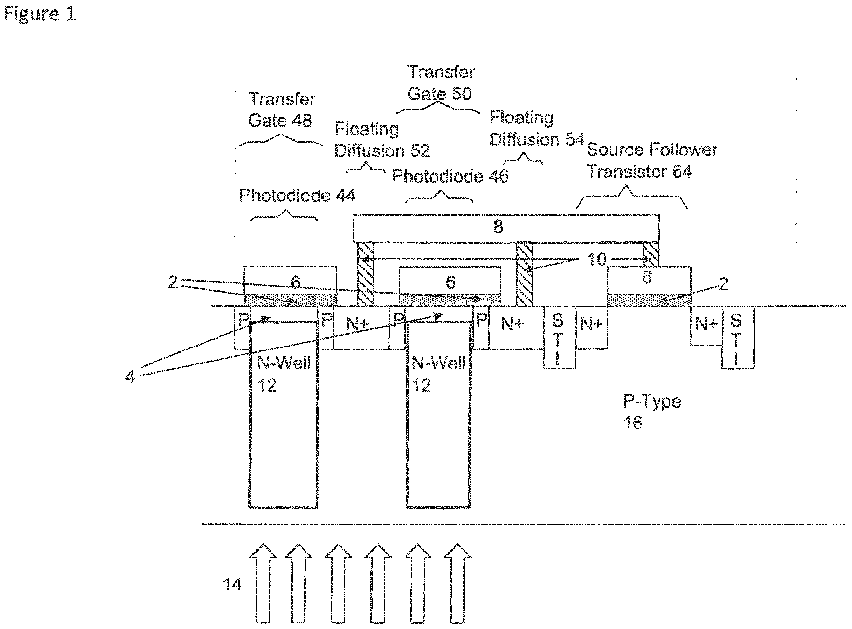

Reference is made to Figure 1 which shows a cross section of a first aspect. The arrangement of Figure 1 shows a back-side illumination (BSI) pixel. For BSI pixels, the photons impact the silicon on the opposite side to the diode implants. The pinned photodiode may be implanted deeper so it is close to where the photons impinge on the silicon surface. This type of pinned photodiode is called a "Vertical Pinned Photodiode".

BSI technology was developed to enable the manufacture of small, light-sensitive pixels as the transistors and metal wires do not obstruct the photons. As shown in Figure 1 the transfer gate is largely on top of the pinned photodiode.

Light 14 impinges on a first N-well 12 and a second N-well 12 in a P-type silicon substrate 16. Each of the N-wells acts as a pinned photodiode 44 and 46 respectively. The photo generated charge from the N-wells is transferred into respective floating diffusion implants 52 and 54 and the capacitance of the floating diffusion implants is used to turn the photo-charge into a voltage. The floating diffusion implant is formed by an N+ implant adjacent the respective well. Contacts 10 are provided between the respective N+ implant and a metal layer 8.

Above each N-Well is a respective pinning layer 4. This isolates the N-Well from the front surface of the silicon as the front surface of the silicon may be damaged during manufacture of the device by the various implants. Separating the N-Well from the front surface may reduce the dark current, i.e. electrons which are thermally generated without any light. On either side of each of the pinning layers is a P region. The N+ implant between the two wells has a P region on either side thereof. The other N+ implant has a P region on the side closer to the N-well and a shallow trench isolation STI region on the side further from the N-well.

Each N-Well is reset and read out using a respective transfer gate 48 and 50. Each transfer gate is provided by a gate oxide 2 in contact with the respective pinning layer 4 and a polysilicon layer 6 above the gate oxide. The transfer gate also overlies the P region and part of the N+ implant on one side of the well and part of the P region on the other side of the N-well.

Also shown in Figure 1 is a source follower transistor 64 which has a gate formed by a gate oxide layer 2 overlying the P-type silicon substrate. On each side of the portion of the P-type silicon substrate under the gate oxide is an N+ implant. The N+ implant closer the N-wells is next to the STI region mentioned above. A further STI region is provided on the other side of the N+ implant further from the N-wells. A polysilicon layer 6 is provided above the gate oxide on which is provided a contact 10, again providing contact with the metal layer 8.

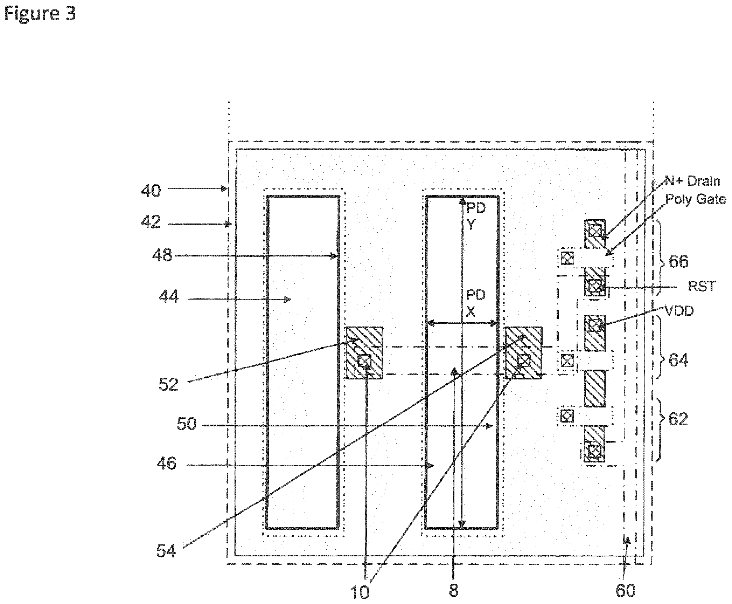

Reference is made to Figure 3 which shows a plan view of the aspect of Figure 1. Those parts which are the same as in Figure 1 are referenced using the same reference number. The plan view shows the first and second diodes 44 and 46. Each pinned photodiode has a width PDX and a length PDY. (Figure 1 shows the depth of the pinned photodiode). The transfer gates 48 and 50 above the respective pinned photodiode is shown in dotted lines. The dotted lines 40 around the pixel show the pixel pitch which can be any suitable size depending on the used process technology. By way of example only, the pixel pitch may be of the order of 2-5μm.

In some aspects, DTI (deep trench isolation) 42 may be provided around each pixel, but for clarity, this is not shown in Figure 1 but is shown in Figure 3. It is possible that charge which is generated in one pixel diffuses across to a neighbouring pixels. This produces crosstalk and is especially problematic on a colour sensor where typically the neighbouring pixel has a different colour filter. It should be appreciated that in contrast to known arrangements, the pixel of some aspects has two or more N-wells.

The floating diffusion part 52 associated with the first pinned photodiode is shown within the region of the transfer gate 48 and the floating diffusion part 54 associated with the second pinned photodiode is shown within the region of the transfer gate 50. The metal layer 8 is shown which extends between the contacts of the floating diffusion implants and the gate of the source follower transistor 64.

Various electronics are required to control the reading and resetting of the pixel and they are provided in an edge region of the pixel adjacent a metal bit line VX which is referenced 60. These electronics may be provided in a region parallel to the y axes of each of the N-wells. The electronics may comprise a reset transistor 66, the source follower transistor 64 and a read transistor 62.

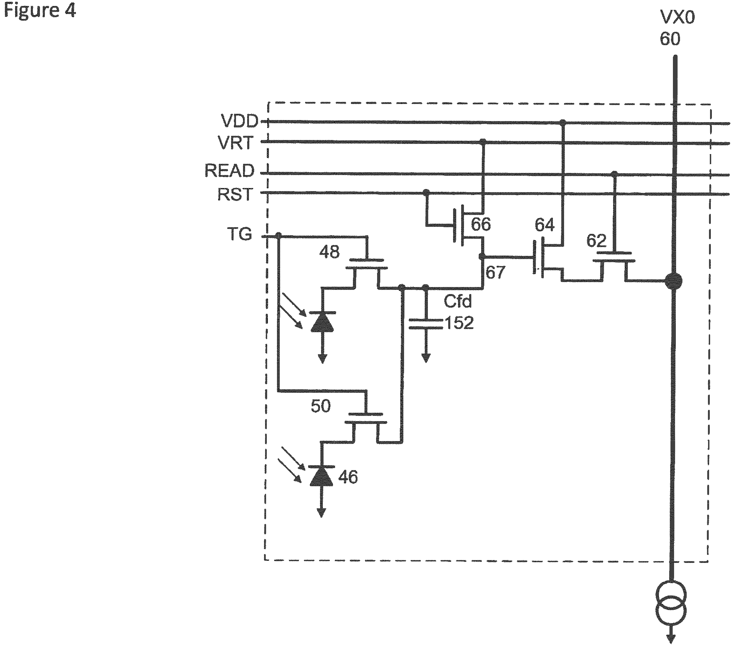

Reference is made to Figure 4 which schematically shows pixel circuitry in which aspects may be provided. The pixel comprises the two pinned photodiodes 44 and 46, the respective transfer gate 48 and 50 associated with each pinned photodiode, the source follower transistor 64, the reset transistor 66 and the read transistor 62. These transistors act to reset, expose and then read out data from the pinned photodiodes. The transfer gate transistors are controlled by a signal TG, the reset transistor 66 is controlled by a signal RST and the readout transistor 62 is controlled by the read signal READ. The source follower transistor has its gate tied to a sense node 67.

In more detail, the reset transistor 66 receives the reset signal RST at its gate, its drain is connected to a voltage VRT and its source is connected to the sense node 67. The source follower transistor 64 has its drain connected to a source follower supply voltage VDD and its source connected to the drain of the read transistor 62. The read signal READ is coupled to the gate of the read transistor 62. The source of the read transistor 62 provides the output voltage Vx. The transfer gate transistors 48 and 50 have their gates coupled to the control signal TG. The drains of the transfer gate transistors are connected to the sense node 67 whilst their sources are connected to the pinned photodiodes.

The transistors typically operate with a pinned photodiode structure and Correlated Double Sampling (CDS) to remove "kTC" noise associated with the reset operation. In Correlated Double Sampling, the output of the pixel is measured twice: once in a reset condition (in this case at "black level" when the only level change is resultant from noise) and once in a condition including the signal (which still includes the "black level" noise). The value measured from the signal condition is then subtracted from the reset condition so as to remove the "black level" noise offset. The double sampling operation also removes fixed noise sources such as variation in the threshold voltages of the source follower transistors.

The pixel needs to have appropriate voltage levels applied at defined time intervals. The voltage levels of the control signal TG (to transfer the pixel signal level to the sense node), RESET (to reset the sense node and pinned photodiodes) and READ (to select the pixel to the Vx line) as well as the pixel power supply (providing VRT and VDD) are controlled.

The charge from the two pinned photodiodes are combined at the sense node 67 are read out at the same time. A capacitance 152 is shown to schematically represent the capacitance of the pinned photodiode.

A discussion of the arrangement of Figure 1 as compared to a current pixel technology will be discussed. In a known pixel, there is only a single N-well for each pixel. For some applications, it may be desirable to have as many pixels on the sensor as possible. For portable devices, the size of a camera module (including the lens) may need to be as small as practical, hence the pixels need to be as small. By way of example only, 0.9μm, 1.1μm or 1.4μm are typical pixel pitches (for both x and y dimensions).

Smaller pixels may produce a sensor which has a relatively poor response to low light levels and/or lower signal-noise ratio. Thus it may be desirable to increase the size of a pixel. However, the inventors have appreciated that simply increasing the size of the N-Well pinned photodiode may be disadvantageous in some applications as the pinning potential may be undesirably increased. The depletion potential can be determined by solution of Poisson's equation:

$$\nabla^2 \varphi(x, y, z) = \frac{\rho_f(x, y, z)}{\varepsilon}$$

Where $\varphi$ is the electrostatic potential, $\rho_f$ is the charge density distribution and $\varepsilon$ is the permittivity of the medium (in this case, silicon). The depletion potential is defined as the maximum value of the electrostatic potential inside of the photodiode at full depletion. As the charge density distribution is a function of the dimensions of the photodiode, the depletion potential is dependent upon the geometry of the photodiode. The depletion potential solution may be dominated by the smallest dimension of the photodiode, and for this reason, pinned photodiodes will usually have one dimension which is considerably narrower than the others. This dimension is often referred to as the "pinning" dimension. For a typical photodiode, the pinning dimension is the Z axis, where Z represents the depth into the silicon. This may be described as a planar photodiode. In the present disclosure, the pinning dimension is in either the X or Y axes. This may be known as a vertical pinned photodiode. An increased diode depletion potential reduces the usable voltage swing at the floating diffusion and may reduce the dynamic range and maximum signal-to-noise ratio of the pixel.

Thus in the aspect of Figures 1, 3 and 4, a single photodiode is replaced by a plurality of vertical pinned photodiode 'fins'. Typically, each of these fins share the same pinning dimension size (PDX in Figure 3). The size may be the same as found in smaller (<2.0μm) pixels. The pinning dimension for example, may be less than 0.3μm, less than 0.5μm, less than 1μm, less than 10μm or less than 50μm. Alternatively, the lateral pinning dimension (PDX) may be represented by a percentage of another dimension of the photodiode, such as the other lateral dimension PDY, or the depth into the substrate PDZ. The pinning dimension PDX may be for example, less than 15% of PDY, less than 30% of PDY, less than 50% of PDY, less than 15% of PDZ or less than 30% of PDZ. This may keep the depletion potential approximately equal to that of the smaller pixels. Preferably, the size of each of the pinned photodiodes are the substantially the same. Each pinned photodiode has its own transfer gate and floating diffusion.

These floating diffusion implants in the aspect shown in Figures 1 and 3 would be connected in parallel and to the gate of the source follower.

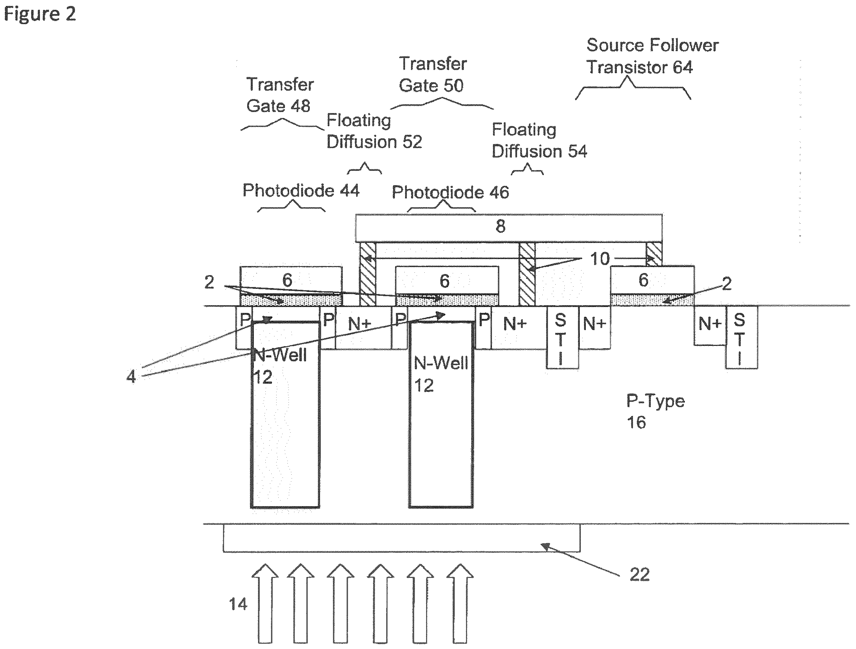

Reference is made to Figure 2 which shows a modification to the aspect shown in Figure 1. In this aspect, a colour filter is provided between the light source and the P-type substrate. An array of pixels may be provided with different colour filters, such as red, blue and green. This is allows a colour image to be captured. The arrangement of Figure 1, without any colour filter, may be used to capture a monochrome image.

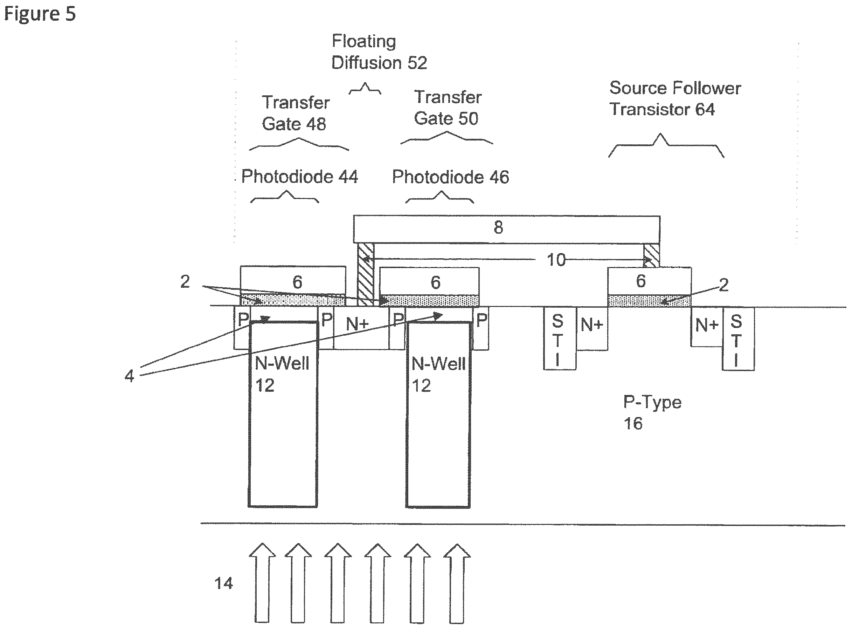

Reference is made to Figure 5 which shows another aspect. Those parts which are the same as in Figure 1 are referenced by the same reference numeral. In Figure 5, there is a single floating diffusion implant 52 which is shared by both pinned photodiodes. In other words, there is a single N+ implant provided between the two N-wells. This N+ region is located as discussed in relation to Figure 1.

This arrangement may be advantageous where it is desirable to reduce the size of the floating diffusion implant to reduce the capacitance of this node. With the reduced capacitance the conversion gain may be improved. The conversion gain is defined as the reduction in voltage for each electron added to the floating diffusion implant and the customary units are $\mu$V/electron.

An improvement in the conversion gain has have one or more of the following advantages:
Each photo-generated charge collected will produce a larger voltage swing at the output of the pixel, hence any noise elsewhere in the system has a smaller effect; and

The equivalent input referred noise will be decreased as noise in the system is multiplied by the conversion gain to convert from voltage to charge or electrons.

In the arrangement of Figure 5, photo-generated charge which is collected by pinned photodiode 44 needs to be transferred to the floating diffusion in one direction (on the right in the Figure) while the photo-generated charge collected by the pinned photodiode 46 needs to be transferred in the opposite direction (to the left in the Figure). During manufacture of the device, there may be a doping profile in the transfer gate which helps to move the charge in the appropriate direction. In the arrangement shown in Figure 5, different doping profiles may be provided for the two different transfer gates, because the transfers are in different directions. This could be involve the use of separate masks and implant steps for the different transfer gates.

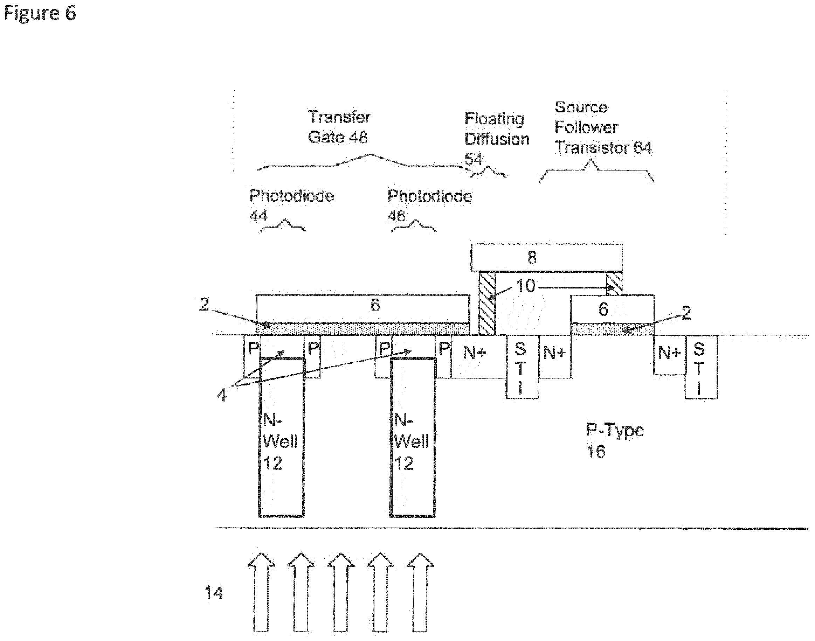

Reference is made to Figure 6 which shows another aspect. Those parts which are the same as in Figure 1 are referenced by the same reference numeral. Figure 6 shows an aspect where the two diode fins are provided under a single transfer gate. This aspect may allow a large full-well capacity to be obtained and to have a good floating diffusion conversion gain. In this aspect, there is a single transfer gate which extends across both of the N-wells and the gap therebetween. No N+ implant is provided between the N-wells, this region now being the P-type substrate. The N+ implant is provided on the side of the second pinned photodiode 46 remote from the first pinned photodiode 44. The contacts 10 provide contact respectively between the N+ implant and the metal layer 8 and between the source follower transistor 64 and the metal layer.

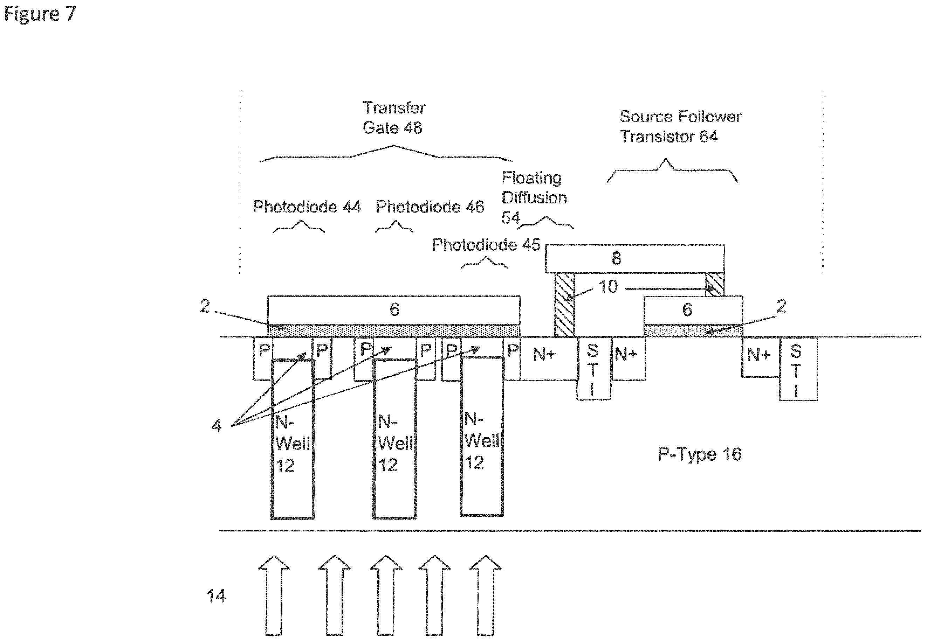

Reference is made to Figure 7 which shows another aspect. Those parts which are the same as in Figure 1 are referenced by the same reference numeral. Figure 7 shows an aspect similar to that of Figure 6 but where three N-wells 12 are provided. A further photodiode 45 is thus provided. The three N-wells are provided under a single transfer gate.

It should be appreciated that aspects may have any suitable number of pinned photodiodes. In this example, the pinned photodiode fins are provided under a single transfer gate. The number of pinned photodiodes provided may be determined by the size of the fins and pixel. Each additional pinned photodiode may increase the total full-well capacity without increasing the depletion potential.

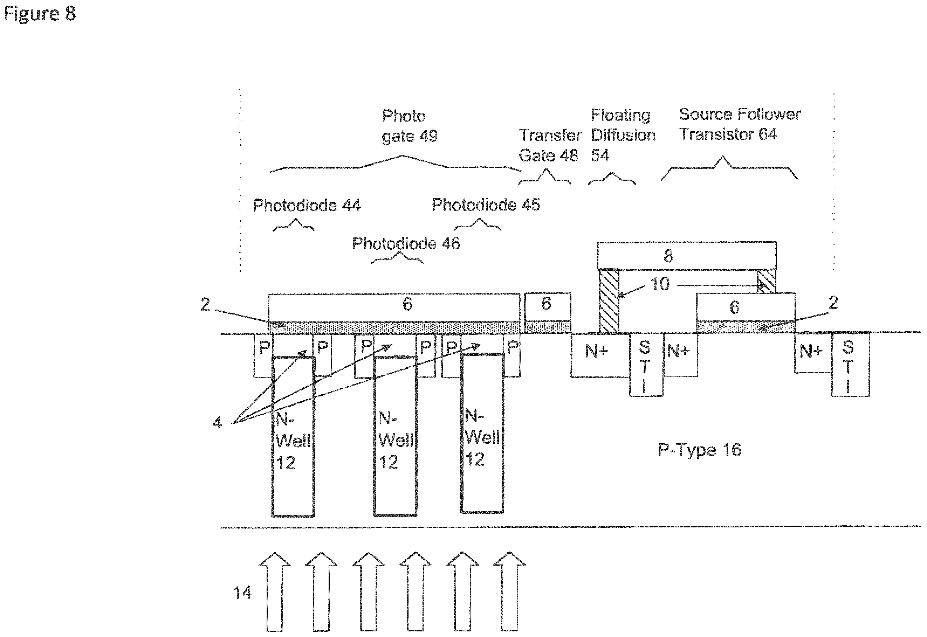

Reference is made to Figure 8 which shows another aspect. Those parts which are the same as in Figure 7 are referenced by the same reference numerals. Figure 8 shows an aspect where there is a polysilicon electrode 49 (a so-called photo-gate) above the all of the pinned photodiodes (three in this example) and a transfer gate 49 next to the photo-gate. The transfer gate 48 is between the photo-gate and the N+ implant. The transfer gate overlies the P-type substrate. For conventional operation, both photo-gate and transfer gate are pulsed high at the appropriate time and the charge transfer occurs in the normal manner. During the integration period, if the transfer gate is at a low voltage and the photo-gate is driven to a sufficiently high voltage, the substrate underneath the photo-gate will enter deep-depletion and accumulate charge (i.e. it will operate as a CCD). Once the gate voltage has been sufficiently screened by the collected charge, the pinned photodiodes will begin collecting charge as normal. Operating in this mode may yield a full-well capacity boost. This may boost pixel performance, for example in relative high light conditions.

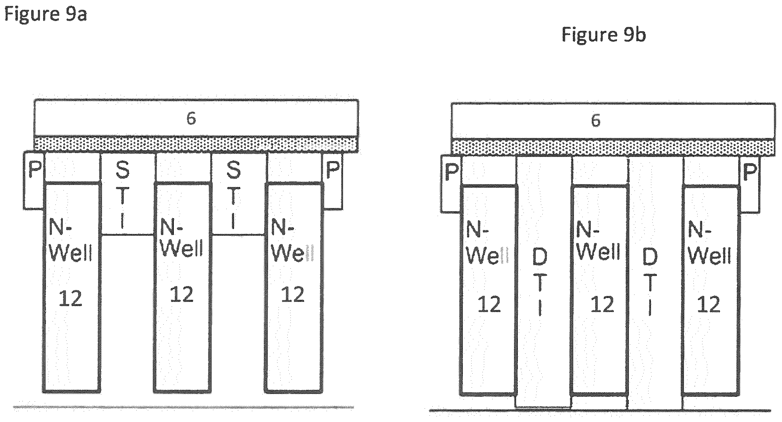

Figure 9a and 9b schematically show two methods of creating the structures described previously. Figure 9a shows the use of shallow trench isolation (STI) to mask the diode implants. This may ensure that the storage regions will be reliably formed. Figure 9b shows the use of deep trench isolation (DTI) is used, which extends further into the silicon than STI. In some cases, the silicon wafer may be thinned down such that the DTI extends through the entire silicon depth.

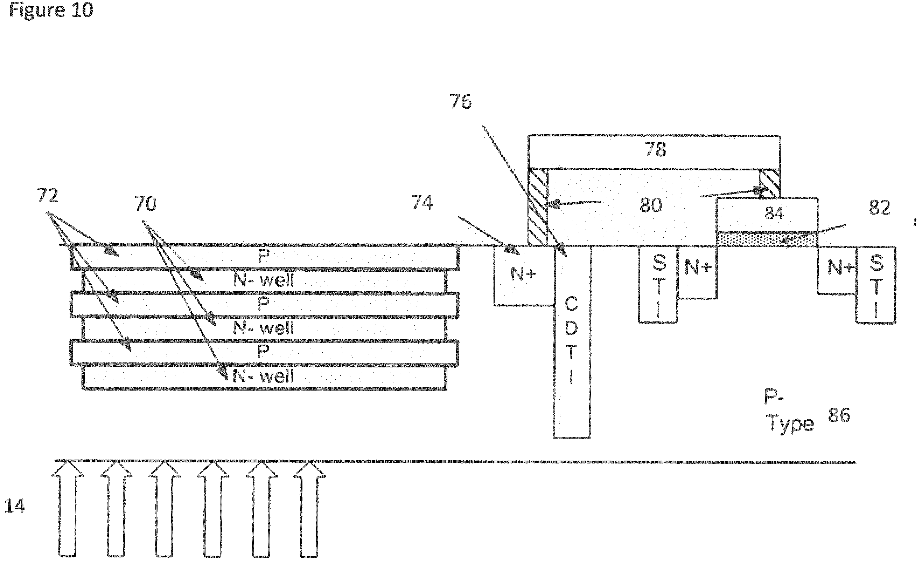

Figure 10 shows an aspect with two or more horizontally-oriented N-Well fins. The N-Well fins 70 are interlaced with pinning layers 72. The number of fins may be any suitable number and the example shown in Figure 10, 2 fins are provided. A vertical transfer gate 76 is provided. The vertical transfer gate 7 may be created with capacitive deep trench isolation (CDTI). This pixel may operates in a similar manner as that described relation to Figure 7. In particular, the transfer gate 76 and floating diffusion implant may be as shown in Figure 7. In this aspect, the CDTI is provided next to the N+ implant region with the P-type substrate between the CDTI and the STI.

The pixel of Figure 10 is a BSI pixel. This pixel may be suitable for FSI process technology.

A number of the discussed aspects have been vertical pinned photodiodes with transfer gates on top of the photodiode. Other aspects may use lateral pinned photodiodes.

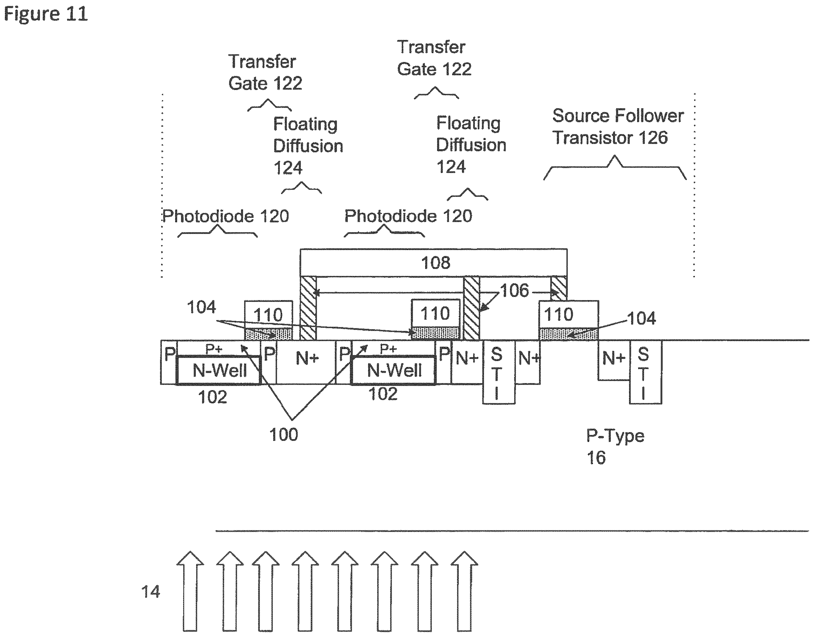

Figure 11 shows a cross-section of one aspect. In this design, each pinned photodiode has a transfer gate and the floating diffusion is split into two parts, one for each pinned photodiode. The advantage of this is that the photo-generated charge transferred in the same way for each pinned photodiode, transfer gate and floating diffusion.

Each of the pinned photodiodes 120 is formed by an N-well 102 which has a respective pinning layer 100 thereon. On each side of each N-well is a p region. Each pinned photodiode has a respective floating diffusion implant region 124 which is positioned as described in relation to the aspect of Figure 1. Likewise the metal layer 108, contacts 106, transfer gates 122 and source follower transistor 126 are positioned in a similar manner to the corresponding elements of Figure 1. The gates comprise gate oxide 104 on which a polysilicon layer 110 is provided, as with the aspect of Figure 1.

Hence, each of the respective elements can have the same doping profile. The doping profile of first pinned photodiode is the same as the doping profile of second pinned photodiode, the doping profile of first transfer gate is the same as the second transfer gate.

Note that the (poly) gate of the transfer gates in aspects are connected together. This connection may be made in poly or with metal as appropriate. This is a difference to prior art 1.75T pixels where there are 4 photodiodes and 4 transfer gates, but the transfer gates are not connected together and are operated consecutively, e.g. to read out the photodiodes covered with red, green1, blue, green2 coloured filters.

Having two floating diffusions may mean that the capacitance of the floating diffusion is increased and so the conversion gain of the floating diffusion is reduced. (The conversion gain is the change in voltage for a change in charge of 1 electron). A reduction in conversion gain will increase the input referred noise of a pixel and so it may be noisier in lower light levels.

$$\#_{e\,noise} = \frac{\left(V_{noise} * C_{fd}\right)}{e}$$

At higher light levels, the noise of a pixel is typically dominated by photon shot noise and this noise is the SQRT number of electrons collected. Hence a higher capacitance floating diffusion allows a greater number of electrons to be collected (full-well capacity) for the same voltage swing and so with a higher number of electrons collected, the signal-noise ratio is improved.

$$SNR_{PSN} = \frac{\#_e}{\sqrt{\#_e}} = \sqrt{\#_e}$$

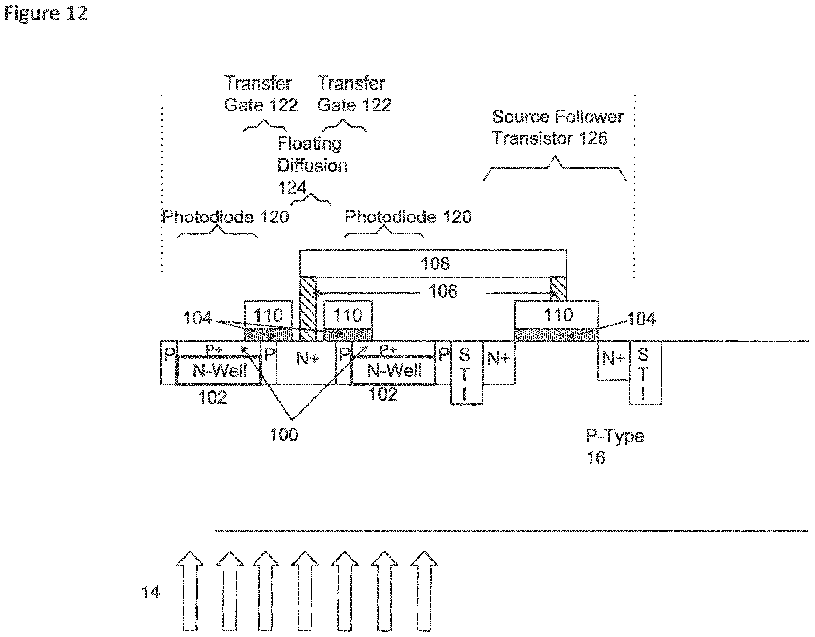

The arrangement of Figure 12 may be used if the design of pixel is optimized for low light levels and so the floating capacitance is to be reduced. There are two photodiodes 120 and two transfer gates 122, but a common floating diffusion implant 124. This will have an arrangement similar to that of Figure 5. As photo-generated charge from the photodiodes are now transferred in different directions, different doping profiles for each of the photodiodes and transfer gates may be provided..

Some aspects may be used for larger pixels by adding more pinned photodiodes, transfer gates and floating diffusions. The floating diffusions may be connected in parallel and also the gates of the transfer gate transistors may also be connected in parallel.

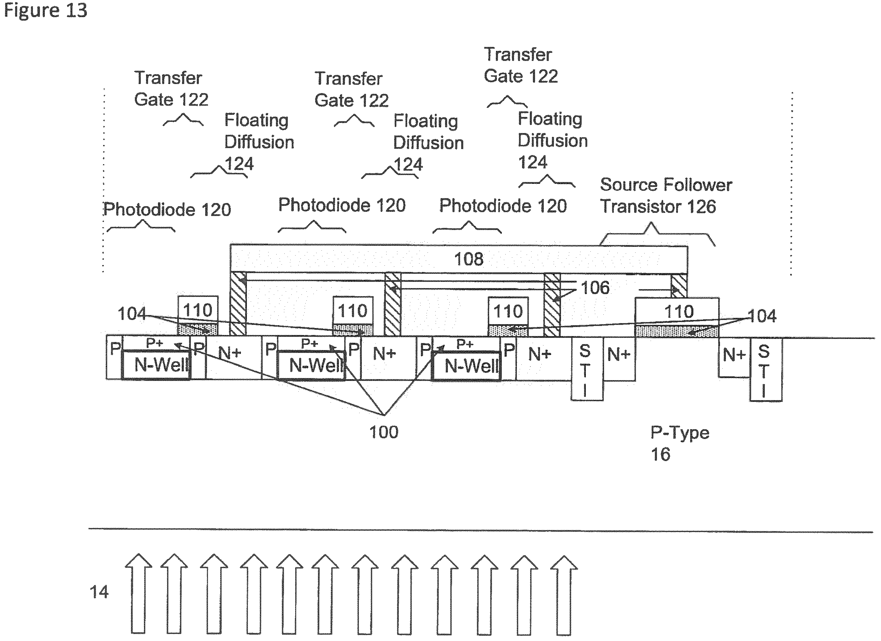

Figure 13 shows a cross section of an aspect of a pixel which has three lateral pinned photodiodes 120. In this implementation, all the photo-generated charge is transferred in the same direction (left to right in Figure 13). The arrangement of Figure 13 is similar to that of Figure 11 but with an extra lateral pinned photodiode and an extra floating diffusion implant.

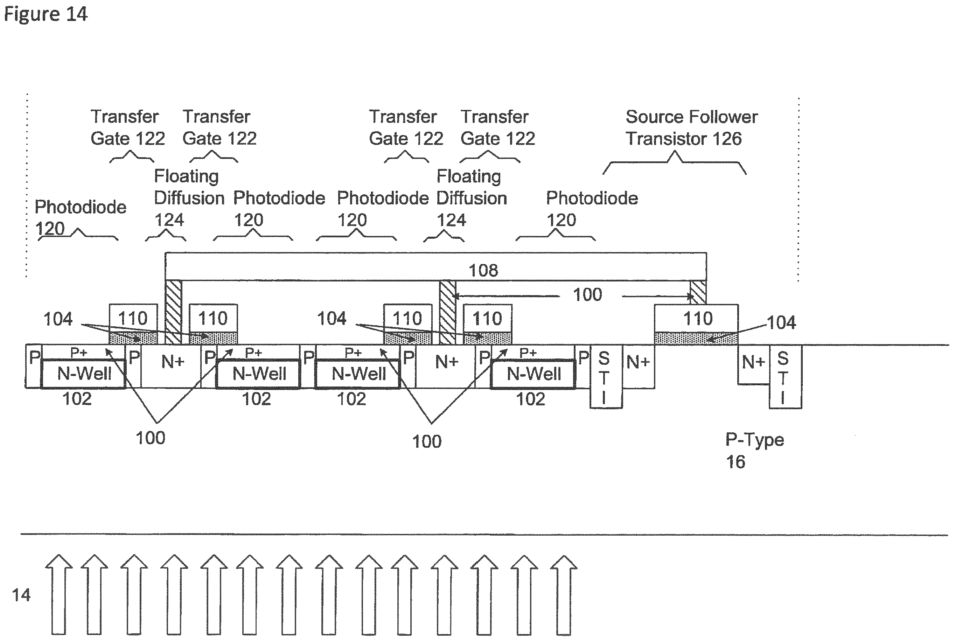

If the pixel is even larger and there are four pinned photodiodes implemented, then they can all operate in the same direction (as discuses in relation to Figure 11 and Figure 13) or implemented as two pairs with each pair having the photo-generated charge transferred in opposite directions. Such an aspect is shown in Figure 14.

Aspects can be used in any suitable circuit.

Figure 4 shows the schematic of the aspects employed in a one example of a pixel. The two pinned photodiodes may be provided with a colour filter. The colour filter will be same for the plurality of pinned photodiodes of the pixel. For simplicity, only a single colour (Green) is shown. The key point is that the same colour filter is used over both pinned photodiodes.

If aspects are used with microlenses, then a single microlens would illuminate both/all pinned photodiodes in the pixel.

Typically, the array will use pixels covered with either Red or Green or Blue colour filters, often arranged in a "Bayer" pattern. However other patterns of colour filters are possible.

Some aspects may have an increased QE and full-well capacity for large photodiodes without increasing the depletion potential. This may produce a pixel which is good at relatively low light levels (as the large area collects a larger number of photons) and/or at relatively high light levels. This may be achieved as the lower depletion potential may give a larger swing and allow for a larger full-well and lower SNR as compared to some prior pixels.

Aspects have been described which have N-wells. It should be appreciated that other aspects may be implemented using P-wells. This may be implemented with an N type substrate.

In some aspects, the distance between two pinned photodiodes of a pixel may be relatively small, for example less than twice the width (x) of the N-well. The distance between the pinned photodiodes is less than the pixel pitch which may be defined for example as the distance between two source-follower transistors.

Aspects may thus provide a pixel which has more than one pinned photodiode. The extent of a pixel may be defined by deep trench isolation, such as described in relation to Figure 4. The deep trench isolation is such that the pinned photodiodes are surrounded. Thus where the pixels are provided in an array, each pixel will be separated from adjacent pixels by its associated deep trench isolation. The deep trench isolation forms a boundary with an adjacent pixel. The deep trench isolation defines an internal region in which the pinned photodiodes of a pixel are provided.

The above described aspects have been described in relation to MOS transistors. It should be appreciated that in other aspects, different types of transistors may be used.

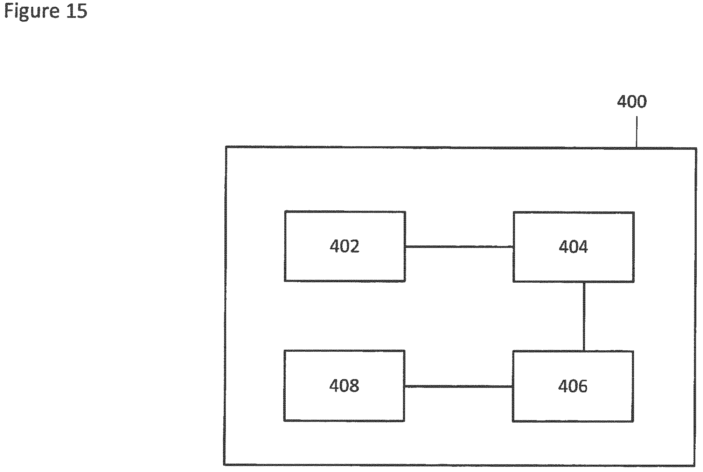

Some aspects may be provided in an electronic device 400 such as shown in Figure 15. The device 400 may comprise any an array of pixels referenced 402. Each of the pixels of the array may be as previously described. An output from the pixel array may be provided to a processor 404. The output of the processor may control for example a display 406 and allow the captured image to be displayed. Alternatively or additionally the captured image data may be output via an interface 408. The interface may provide an output to another device and/or to a communications link. The communications link may be a radio link, the internet, a wireless local area network, a mobile communications network or any other suitable link.

It should be appreciated that the device may be any suitable device. By way of example only and without limitation, that device may be a mobile telephone, smart phone, tablet, computer, camera or the like.

Various aspects with different variations have been described here above. The present invention is limited only as defined in the following claims.

**Claims**

1. A pixel comprising:

   a plurality of vertical pinned photodiodes (44, 45, 46), each vertical pinned photodiode having dimensions in x, y and z directions representing a width, a length and a depth, into a substrate (16) respectively, wherein a pinning dimension of each of the vertical pinned photodiodes is a narrowest dimension of each of the vertical pinned photodiodes and is the dimension in the x direction or the dimension in the y direction , each vertical pinned photodiode being configured to receive incoming light (14) via a back surface defined in the x and y directions;
   a single floating diffusion implant (54);
   a single transfer gate (48);
   **characterized in that**:

   the pixel comprises a single photo-gate (49) above the vertical pinned photodiodes (44, 45, 46);
   **in that** the single transfer gate (48) is adjacent the photo-gate (49) and between the single photo-gate (49) and the single floating diffusion implant (54); and
   **in that** the single photo-gate (49) and the single transfer gate (48) are configured such that, in use, the single photo-gate (49) and the single transfer gate (48) are at a high voltage to allow a charge to be transferred from each of said plurality of vertical pinned photodiodes (44, 45, 46) to the floating diffusion implant (54), such that the charge from said plurality of vertical pinned photodiodes (44, 45, 46) is combined at said floating diffusion implant (54), and during an integration period the single photo-gate (49) is at a high voltage and the single transfer gate (48) is at a low voltage.

2. A pixel as claimed in claim 1, wherein the floating diffusion implant (54) is provided on one side of one of said vertical pinned photodiodes (44, 45, 46) remote from another of said vertical pinned photodiodes (44, 45, 46).

3. A pixel as claimed in any preceding claim, comprising a source follower transistor (64) and wherein the floating diffusion implant (54) is provided with a contact (10), a gate of said source follower transistor (64) being provided with a contact (10), said contacts (10) each being in contact with a common metal part (8).

4. A pixel as claimed in any preceding claim, wherein deep trench isolation is provided around the pixel.

5.  An array of pixels (402) comprising:
    a plurality of pixels as claimed in any preceding claim.

6.  An electronic device (400) comprising:

    an array of pixels (402) as claimed in claim 5 configured to capture image data;
    at least one processor (404) configured to process said captured image data; and
    a display (406) for displaying said processed captured image data.


**Patentansprüche**

1.  Pixel, aufweisend:

    mehrere vertikale gepinnten Photodioden (44, 45, 46), wobei jede vertikale gepinnte Photodiode Ausmaße in x-, y- und z-Richtungen, die eine Breite, eine Länge und eine Tiefe darstellen, in ein Substrat (16) hat, wobei ein Pinning-Ausmaß jeder der vertikalen gepinnten Photodioden ein schmalstes Ausmaß jeder der vertikalen gepinnten Photodioden ist und das Ausmaß in der x-Richtung oder das Ausmaß in der y-Richtung ist, wobei jede vertikale gepinnte Photodiode konfiguriert ist, um einfallendes Licht (14) über eine in den x- und y-Richtungen definierte Rückseite zu empfangen;
    ein einzelnes Floating-Diffusion-Implantat (54);
    ein einzelnes Transfer-Gate (48),
    **dadurch gekennzeichnet, dass**
    das Pixel ein einzelnes Photo-Gate (49) über den vertikalen gepinnten Photodioden (44, 45, 46) aufweist;
    das einzelne Transfer-Gate (48) dem Photo-Gate (49) benachbart ist und zwischen dem einzelnen Photo-Gate (49) und dem einzelnen Floating-Diffusion-Implantat (54) ist; und
    das einzelne Photo-Gate (49) und das einzelne Transfer-Gate (48) so konfiguriert sind, dass das einzelne Photo-Gate (49) und das einzelne Transfer-Gate (48) im Einsatz auf einer hohen Spannung sind, um zu ermöglichen, dass eine Ladung von jeder der mehreren vertikalen gepinnten Photodioden (44, 45, 46) zu dem Floating-Diffusion-Implantat (54) übertragen wird, so dass die Ladung aus den mehreren vertikalen gepinnten Photodioden (44, 45, 46) an dem Floating-Diffusion-Implantat (54) kombiniert wird, und während einer Integrationsperiode das einzelne Photo-Gate (49) auf einer hohen Spannung ist und das einzelne Transfer-Gate (48) auf einer niedrigen Spannung ist.

2.  Pixel nach Anspruch 1, bei welchem das Floating-Diffusion-Implantat (54) auf einer Seite von einem der vertikalen gepinnten Photodioden (44, 45, 46) entfernt von einer anderen der vertikalen gepinnten Photodioden (44, 45, 46) vorgesehen ist.

3.  Pixel nach einem der vorhergehenden Ansprüche, welches einen Sourcefolger-Transistor (64) aufweist und bei welchem das Floating-Diffusion-Implantat (54) mit einem Kontakt (10) versehen ist, wobei ein Gate des Sourcefolger-Transistors (64) mit einem Kontakt (10) versehen ist, wobei die Kontakte (10) jeweils mit einem gemeinsamen Metallteil (8) in Kontakt stehen.

4.  Pixel nach einem der vorhergehenden Ansprüche, bei welchem eine tiefe Grabenisolation um das Pixel vorgesehen ist.

5.  Pixelarray (402), aufweisend
    mehrere Pixel nach einem der vorhergehenden Ansprüche.

6.  Elektronische Vorrichtung (400), aufweisend:

    ein Pixelarray (402) nach Anspruch 5, das konfiguriert ist, um Bilddaten zu erfassen;
    wenigstens einen Prozessor (404), der konfiguriert ist, um die erfassten Bilddaten zu verarbeiten; und
    eine Anzeige (406) zum Anzeigen der verarbeiteten erfassten Bilddaten.


**Revendications**

1.  Pixel comprenant :

    une pluralité de photodiodes épinglées verticales (*vertical pinned photodiodes*) (44, 45, 46), chaque photodiode épinglée verticale ayant des dimensions dans les directions x, y et z représentant une largeur, une longueur et une profondeur, dans un substrat (16), respectivement, dans lequel une dimension d'épinglage de chacune des photodiodes épinglées verticales est la plus étroite dimension de chacune des photodiodes épinglées verticales et est la dimension dans la direction x ou la dimension dans la direction y, chaque photodiode épinglée verticale étant configurée pour recevoir de la lumière entrante (14) via une surface arrière définie dans les directions x et y ;
    un unique implant de diffusion flottante (54) ;
    une unique grille de transfert (48) ;
    **caractérisé en ce que** :

    le pixel comprend une unique photo-grille (49) au-dessus des photodiodes épinglées verticales (44, 45, 46) ;

l'unique grille de transfert (48) est adjacente à la photo-grille (49) et se trouve entre l'unique photo-grille (49) et l'unique implant de diffusion flottante (54) ; et

l'unique photo-grille (49) et l'unique grille de transfert (48) sont configurées de telle sorte que, en utilisation, l'unique photo-grille (49) et l'unique grille de transfert (48) sont soumises à une haute tension pour permettre le transfert d'une charge de chacune de ladite pluralité de photodiodes épinglées verticales (44, 45, 46) vers l'implant de diffusion flottante (54), de telle sorte que la charge de ladite pluralité de photodiodes épinglées verticales (44, 45, 46) est combinée au niveau dudit l'implant de diffusion flottante (54), et pendant une période d'intégration, l'unique photo-grille (49) est soumise à une haute tension et l'unique grille de transfert (48) est soumise à une basse tension.

2. Pixel selon la revendication 1, dans lequel l'implant de diffusion flottante (54) est prévu sur un côté de l'une desdites photodiodes épinglées verticales (44, 45, 46) à distance d'une autre desdites photodiodes épinglées verticales (44, 45, 46).

3. Pixel selon l'une quelconque des revendications précédentes, comprenant un transistor à source suiveuse (64) et dans lequel l'implant de diffusion flottante (54) est prévu avec un contact (10), une grille dudit transistor de source suiveuse (64) étant prévue avec un contact (10), lesdits contacts (10) étant chacun en contact avec une pièce métallique commune (8).

4. Pixel selon l'une quelconque des revendications précédentes, dans lequel une isolation en tranchée profonde est prévue autour du pixel.

5. Réseau de pixels (402) comprenant :
une pluralité de pixels selon l'une quelconque des revendications précédentes.

6. Dispositif électronique (400) comprenant :

un réseau de pixels (402) selon la revendication 5 qui est configuré pour capturer des données d'image ;
au moins un processeur (404) qui est configuré pour traiter lesdites données d'image capturées ; et
un affichage (406) pour afficher lesdites données d'image capturées et traitées.

Figure 1

Transfer
Gate 50

Transfer
Gate 48    Floating          Floating
           Diffusion 52      Diffusion 54  Source Follower
                   Photodiode 46          Transistor 64

Photodiode 44

8

10

2        6              6              6        2

P    P  N+  P    P  N+   S    N+      N+   S
                        T               T
                        I               I

N-Well          N-Well
12              12

4                              P-Type
                               16

14

EP 3 082 165 B1

## Figure 2

EP 3 082 165 B1

Figure 3

Figure 4

VX0
60

VDD

VRT

READ

RST

TG

66

64

62

48

67

Cfd

152

50

46

EP 3 082 165 B1

13

Figure 5

Figure 6

Figure 7

EP 3 082 165 B1

Transfer
Gate 48

Source Follower
Transistor 64

Floating
Diffusion
54

Photodiode 44    Photodiode 46

Photodiode 45

8

10

2        6        2

P | P    P | P | P | P    N+    S T I    N+    N+    S T I

N-Well 12    N-Well 12    N-Well 12

4

P-Type 16

14

Figure 8

Photo
gate 49

Transfer | Floating
Gate 48 | Diffusion
54

Source Follower
Transistor 64

Photodiode 44          Photodiode 45

Photodiode 46

8

10

2          6          6          6          2

P | P    P | P P | P    N+ | S T I | N+    6    N+ | S T I

4          N-Well 12    N-Well 12    N-Well 12    P-Type 16

14

EP 3 082 165 B1

17

Figure 9b

Figure 9a

Figure 10

Figure 11

EP 3 082 165 B1

Figure 12

Transfer Gate 122    Transfer Gate 122

Floating Diffusion 124

Source Follower Transistor 126

Photodiode 120    Photodiode 120

108

106

104    110    110    110    104

P | P+ | P | N+ | P | P+ | P | S T I | N+ | N+ | S T I

N-Well    N-Well

102    102

100

P-Type 16

14

EP 3 082 165 B1

Figure 13

Transfer Gate 122
Transfer Gate 122
Transfer Gate 122

Floating Diffusion 124
Floating Diffusion 124
Floating Diffusion 124

Photodiode 120
Photodiode 120
Photodiode 120

Source Follower Transistor 126

108

106

104 110 110 110 110 104

P P+ N-Well P N+ P P+ N-Well P N+ P P+ N-Well P N+ S T I N+ N+ S T I

100

P-Type 16

14

EP 3 082 165 B1

Figure 14

EP 3 082 165 B1

Figure 15

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2015006008 A1